# EUROPÄISCHE PATENTSCHRIFT

(11) **EP 1 737 997 B1**
(45) Veröffentlichungstag und Bekanntmachung des Hinweises auf die Patenterteilung: **12.11.2008**
(21) Anmeldenummer: 05716492.3
(22) Anmeldetag: 01.04.2005
(51) Int. Cl.: C23C 14/50, C23C 14/24

(54) **VORRICHTUNG ZUM BEIDSEITIGEN BESCHICHTEN VON SUBSTRATEN MIT EINER HYDROPHOBEN SCHICHT**
DEVICE FOR COATING BOTH SIDES OF A SUBSTRATE WITH A HYDROPHOBIC LAYER
DISPOSITIF DE REVETEMENT BILATERAL DE SUBSTRATS AU MOYEN D'UNE COUCHE HYDROPHOBE

(30) Priorität: 06.04.2004 DE 102004018435
(43) Veröffentlichungstag der Anmeldung: 03.01.2007
(73) Patentinhaber: Carl Zeiss Vision GmbH, 73430 Aalen (DE); Leybold Optics GmbH, 63775 Alzenau (DE)
(72) Erfinder: ZÜLTZKE, Walter, 63477 Maintal (DE); FUHR, Markus, 65817 Eppstein (DE); WINTER, Karl-Heinz, 73457 Essingenn (DE); WICHT, Manfred, 89551 Königsbronn (DE)
(74) Vertreter: Weller, Wolfgang
(86) Internationale Anmeldenummer: PCT/EP2005/003432
(87) Internationale Veröffentlichungsnummer: WO 2005/098082

(56) Entgegenhaltungen:
- EP-A- 0 698 798
- GB-A- 1 082 562
- US-A- 5 858 450
- PATENT ABSTRACTS OF JAPAN Bd. 1997, Nr. 12, 25. Dezember 1997 (1997-12-25) & JP 09 202965 A (ULVAC JAPAN LTD), 5. August 1997 (1997-08-05)

## Beschreibung

Die Erfindung betrifft eine Vorrichtung gemäß dem Patentanspruch 1 zum beidseitigen Beschichten von Substraten mit einer hydrophoben Schicht in einer Vakuumbeschichtungsanlage, mit einem Substrathalter und mit einem auf einer Seite des Substrathalters angeordneten ersten Verdampfer zum Verdampfen eines die hydrophobe Schicht bildenden Stoffes. Weiter betrifft die Erfindung ein Verfahren zum beidseitigen Beschichten von Substraten gemäß dem Patentanspruch 10.

Eine derartige Vorrichtung ist aus der DE 44 30 363 A1 bekannt.

Eine hydrophobe, also wasserabweisende Schicht auf einem flächigen Substrat dient dazu, einen Niederschlag von Feuchtigkeit bzw. ein Anhaften von Feuchtigkeit auf der Oberfläche des flächigen Substrates zu verhindern. Diese Schicht verhindert jedoch nicht nur ein Anhaften von Feuchtigkeit, sondern verhindert ein Anhaften von jeglicher Art von Schmutz und auch von Fasern oder Fusseln. Diese Schicht sorgt auch für eine Glättung der Oberfläche der Substrate.

Substrate, die mit einer hydrophoben Schicht versehen werden, sind beispielsweise optische Linsen, rahmenartige Bauteile oder Brillengläser aus einem klarsichtigen Kunststoff oder Brillengläser aus Mineralglas, die mit einer Entspiegelung versehen sind.

In der eingangs erwähnten DE 44 30 363 A1 ist eine Vakuumbeschichtungsanlage beschrieben, in der flächige Substrate mit mehreren Schichten unterschiedlichen Zweckes beschichtet werden können, abschließend mit einer hydrophoben Schicht.

So werden auf Brillengläser, hergestellt aus einem Substrat aus klarsichtigem Kunststoff, beispielsweise Diallyldiethylenglykolcarbonat, weitere Schichten aufgetragen, die die Eigenschaften des Substrates verbessern sollen. Solche Schichten sind beispielsweise abriebfeste Schichten, um die Kratzfestigkeit zu erhöhen, reflexreduzierende Schichten, um Antireflexionseigenschaften zu erzielen, Deckschichten, um diese zusätzlich aufgebrachten Schichten abzudecken.

Als äußerste Schicht wird dann die hydrophobe Schicht aufgebracht.

Zum Aufbringen der Schichten weist die Vakuumbeschichtungsanlage eine evakuierbare Kammer auf, in der die zu behandelnden Substrate auf einem Substrathalter aufgenommen sind.

Der Substrathalter weist beispielsweise die Form einer Kalotte auf, auf deren Oberfläche die einzelnen Substrate verteilt angeordnet sind. Die Substrate selbst sind dabei beispielsweise in Federringen gehalten.

Da eine beidseitige Beschichtung erwünscht ist, wurden die Kalotten so weitergebildet, dass die Substrate gewendet werden können. Dazu wurde die Kalotte in einzelne, pyramidenartig aneinandergeordnete, trapezartige Segmente unterteilt, die auch als Paddel bezeichnet werden, die zum Wenden der Substrate um ihre Längsachse gedreht werden können.

In einer solchen Standard-Vakuumanlage werden die Schichten mittels eines Elektronenstrahlverdampfers aufgedampft.

Eine optionale Plasmaquelle enthält eine Elektronen emittierende Kathode, die über eine Magnetspulenanordnung beschleunigt werden, und zwar von der Plasmaquelle aus in Richtung kuppelförmigem Substrathalter gerichtet. Diese beschleunigten Elektronen bilden mit einem in die Vakuumanlage eingeführten Edelgas, in erster Linie Argon, ein Glimmentladungs-Plasma. Das aufzuschichtende Material wird vom Elektronenstrahlverdampfer verdampft und das verdampfte Material durchläuft das Plasma, wobei es ionisiert und aktiviert wird. Da keine Kupplung zwischen Plasmaquelle und Verdampferquelle besteht, kann in dem Verdampfer jegliches verdampfbare Ausgangsmaterial zur Herstellung der unterschiedlichen Beschichtungen eingesetzt werden.

Die abschließende hydrophobe Schicht wird beispielsweise aus Tetramethyldisiloxan (TMDS) hergestellt.

Da die Substrate beidseits beschichtet werden müssen, und sowohl Plasmaquelle als auch Elektronenstrahlquelle auf einer Seite des Substrathalters angeordnet sind, üblicherweise unterhalb des kuppelförmigen Substrathalters, ist es möglich, die Schichtfolge auf einer Seite des Substrates komplett fertig zu stellen und anschließend das Substrat zu wenden und erneut dieselbe Schichtfolge nach und nach aufzubringen.

Es ist auch möglich, wenn man Wendevorrichtungen einsetzt, zunächst eine erste Schicht auf der einen Seite aufzubringen, das Substrat zu wenden und eine gleiche Schicht auf der gegenüberliegenden Seite aufzubringen. Anschließend wird auf dieser Seite die zweite Schicht aufgebracht, das Substrat erneut gewendet und dann auf der gegenüberliegenden Seite die zweite Schicht aufgebracht.

So können dann durch Wenden die einzelnen Schichten jeweils auf beiden Seiten nach und nach aufgebaut werden.

Setzt man das erstgenannte Verfahren ein, also dass man auf einer Seite des Substrates die komplette Schichtfolge aufbringt und anschließend das so einseitig beschichtete Substrat wendet, so wurde festgestellt, dass beim Beschichten der zweiten Seite die auf der gegenüberliegenden Seite bereits aufgetragene äußerste hydrophobe Schicht ungünstig beeinträchtigt wird.

So wurde festgestellt, wenn beispielsweise beim Herstellen einer Anti-Reflexionsschicht eine Ionenquelle eingesetzt wird, oder wenn bei dem Beschichtungsprozess das sogenannte IAD = Ion Assisted Deposition-Verfahren herangezogen wird, dass streuende Ionen die hydrophobe Wirkung der Schicht wieder teilweise eliminieren.

Dieser Effekt ist um so stärker zu beobachten, wenn die Substrate in Federringen eingelegt sind, die einen Spalt rund um das Substrat erzeugen.

Werden bei Vorrichtungen, die eine Wendemöglichkeit vorsehen, die Schichten nach und nach beidseitig aufgetragen, sind zahlreiche Wendevorgänge notwendig, insbesondere auch ein letzter Wendevorgang zum Auftragen der hydrophoben Schicht auf den beiden Seiten.

Es ist daher Aufgabe der vorliegenden Erfindung eine Vorrichtung der eingangs genannten Art dahingehend weiter zu entwickeln, dass flächige Substrate einfach und effektiv beidseitig mit einer hydrophoben Schicht versehen werden können.

Erfindungsgemäß wird die Aufgabe dadurch gelöst, dass auf der der einen Seite gegenüberliegenden anderen Seite ein zweiter Verdampfer angeordnet ist.

Diese Maßnahme hat den Vorteil, dass unabhängig davon wie der Substrathalter ausgebildet ist, für das Beschichten mit der hydrophoben Schicht auf beiden Seiten des Substrates ein Verdampfer zur Verfügung steht.

Unabhängig davon, welche Beschichtungsbedingungen während der Herstellung der unter der hydrophoben Schicht liegenden Schichten herangezogen werden, und unabhängig davon, ob diese Schichten nach und nach auf beiden Seiten oder zunächst jeweils nur auf einer Seite aufgebracht werden, stehen für das Herstellen der hydrophoben Schicht auf beiden Seiten jeweils ein Verdampfer zur Verfügung.

Das Aufbringen der hydrophoben Schicht ist bezüglich der Maßhaltigkeit der Schichtdicke weniger kritisch als das Aufbringen beispielsweise einer Anti-Reflexionsschicht oder das Aufbringen einer kratzfesten Schicht, bei denen es unbedingt notwendig ist, sehr enge Schichtdickentoleranzen und auch Schichtdickenstrukturen einzuhalten. Die gegenüber den Bedingungen beim Aufbringen dieser Schichten empfindliche hydrophobe Schicht, insbesondere gegenüber den Ionenstrahlen, kann somit unter speziell auf diese Schicht zugeschnittene optimalen Bedingungen durchgeführt werden.

Es braucht auch kein abschließender Wendevorgang durchgeführt werden, um diese hydrophoben Schichten aufzubringen, denn diese werden durch die beiden auf den gegenüberliegenden Seiten vorhandenen Verdampfer aufgebracht.

In einer weiteren Ausgestaltung der Erfindung weist der zweite Verdampfer ein Behältnis auf, das mehrere Austrittsöffnungen aufweist.

Diese konstruktiv einfache Ausgestaltung ermöglicht es, das zusätzliche Vorsehen eines zweiten Verdampfers äußerst kostengünstig und apparativ wenig aufwendig durchzuführen. Wie zuvor erwähnt, ist die Einhaltung enger Toleranzgrenzen hier nicht so kritisch, so dass es ausreicht, die zu verdampfende Substanz in dem Behälter aufzunehmen, bei der Beschichtung zu verdampfen, wobei dann die verdampfte Substanz aus den Austrittsöffnungen austritt.

In einer weiteren Ausgestaltung der Erfindung ist der Behälter in einer Halterung lösbar aufgenommen.

Diese Maßnahme eröffnet ein flexibles Handhaben, insbesondere beim Nachfüllen oder auch bei einem Nachrüsten einer bestehenden Anlage mit einem zweiten Verdampfer.

In einer weiteren Ausgestaltung der Erfindung ist zwischen Behälter und Substrathalter eine Blende angeordnet.

Durch Vorsehen dieser Blende, die ebenfalls ein einfaches Bauelement darstellt, kann der aus dem Verdampfer austretende Substanzstrom entsprechend auf die vom Substrathalter aufgenommenen einzelnen Substrate zur Erzielung einer gleichmäßigen Schichtdicke in gewünschter Weise gelenkt, abgeschirmt und/oder verteilt werden.

In einer weiteren Ausgestaltung sind erster und zweiter Verdampfer als einzelne Gerätschaften ausgebildet.

Diese Maßnahme hat den Vorteil, dass je nach den örtlichen Gegebenheiten in der Vakuumbeschichtungsanlage die beiden Verdampfer beidseits des Substrathalters angeordnet werden können.

In einer weiteren Ausgestaltung der Erfindung sind erster und zweiter Verdampfer gleich ausgebildet.

Diese Maßnahme trägt zur weiteren Vereinfachung und Kostenreduzierung bei.

In einer weiteren Ausgestaltung der Erfindung ist der erste Verdampfer Bauteil eines Elektronenstrahlverdampfers.

Diese Maßnahme hat den Vorteil, dass der in einer Standard-Vakuumanlage ohnehin vorhandene Elektronenstrahlverdampfer dazu herangezogen wird, als erster Verdampfer zum Verdampfen der Substanzen zur Herstellung der hydrophoben Schicht zu dienen.

In einer weiteren Ausgestaltung der Erfindung ist der erste Verdampfer unterhalb des Substrathalters und der zweite Verdampfer oberhalb des Substrathalters angeordnet.

Diese Maßnahme hat den Vorteil, dass durch diese Anordnung der Substrathalter jeweils beidseitig großflächig mit der Substanz zum Aufbauen der hydrophoben Schicht beaufschlagt werden kann.

In einer weiteren Ausgestaltung der Erfindung ist der Substrathalter kalottenförmig.

Diese an sich bekannte Maßnahe hat den Vorteil, dass dieser übliche kuppelförmige Substrathalter eingesetzt werden kann, auf dem dann die unter der hydrophoben Schicht angeordneten Schichten in der gewünschten Qualität herstellt werden können, beispielsweise unter Einsatz des IAD- oder PIAD-Verfahrens, und dann abschließend durch die beiden Verdampfer beidseits die hydrophoben Schichten aufgebracht werden können.

Es versteht sich, dass die vorstehend genannten und die nachstehend noch zu erläuternden Merkmale nicht nur in den angegebenen Kombination, sondern auch in anderen Kombinationen oder in Alleinstellung einsetzbar sind, ohne den Rahmen der vorliegenden Erfindung zu verlassen.

Die Erfindung wird nachfolgend anhand einiger ausgewählter Ausführungsbeispiele in Zusammenhang mit den beiliegenden Zeichnungen näher beschrieben und erläutert. Es zeigen:
- Fig. 1: einen Schichtaufbau auf einem Substrat aus Kunststoffmaterial,
- Fig. 2: stark schematisiert eine Vakuumbeschichtungsanlage zum Aufbringen solcher Schichten, und
- Fig. 3: stark schematisiert und vergrößert einen Verdampfer, der zum Herstellen einer hydrophoben Schicht in der in Fig. 2 gezeigten Vakuumbeschichtungsanlage eingesetzt wird.

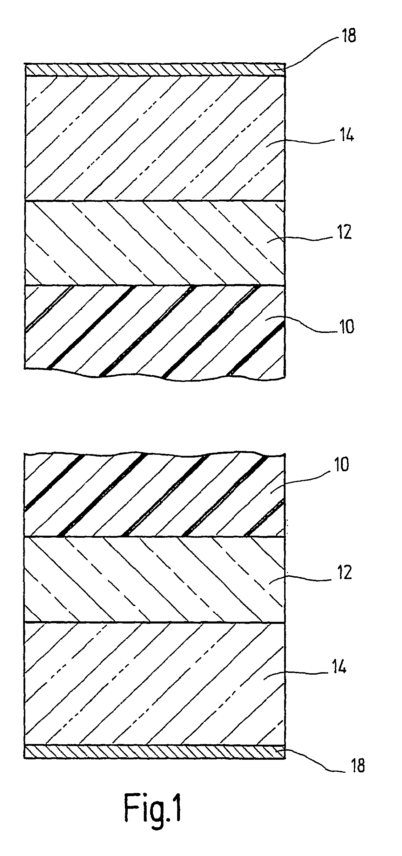

Ein in Fig. 1 dargestelltes Substrat 10 dient als Kunststoffglas in einer Brille.

Das Substrat 10 ist beispielsweise aus einem in der Brillen-Optik bevorzugten Duroplasten mit der Bezeichnung CR 39 hergestellt, einem Diallyldiethylenglykolcarbonat.

Weitere Kunststoffe zur Bildung des Substrates können beispielsweise Polymethylmethacrylate, Polystyrole und Polycarbonate sein.

Beidseits auf dem Substrat 10 ist zunächst eine abriebfeste Schicht 12 aufgebracht, beispielsweise durch ein Plasma-Ion-Assisted-Deposition-Verfahren (PIAD-Verfahren), wie es beispielsweise näher in der DE 44 30 363 A1 beschrieben ist.

Die abriebfeste Schicht 12 besteht beispielsweise aus einem Borosilicatglas mit einer Schichtdicke von etwa 500 Nanometer. Das Borosilicatglas hat eine um den Faktor 100 größere Härte als der Kunststoff, dessen Härte im Bereich von 180 bis 200 N/min² liegt.

Auf der abriebfesten Schicht 12 ist auf beiden Seiten außerdem eine reflexreduzierende Schicht 14 aufgebracht.

Diese reflexreduzierende Schicht 14 kann beispielsweise aus einer Abfolge von unterschiedlichen Oxidschichten bestehen, beispielsweise TiO₂, SiO₂, TiO₂, Al₂O₃ und SiO₂.

Abschließend ist beidseitig eine hydrophobe Schicht 18 aus Tetramethyldisiloxan (TMDS) aufgetragen. Die Schichtdicke beträgt etwa 10 - 15 nm. Die hydrophobe Schicht 18 selbst besteht aus einer dreidimensional vernetzten SiO₂-Struktur mit wasserabweisenden Eigenschaften.

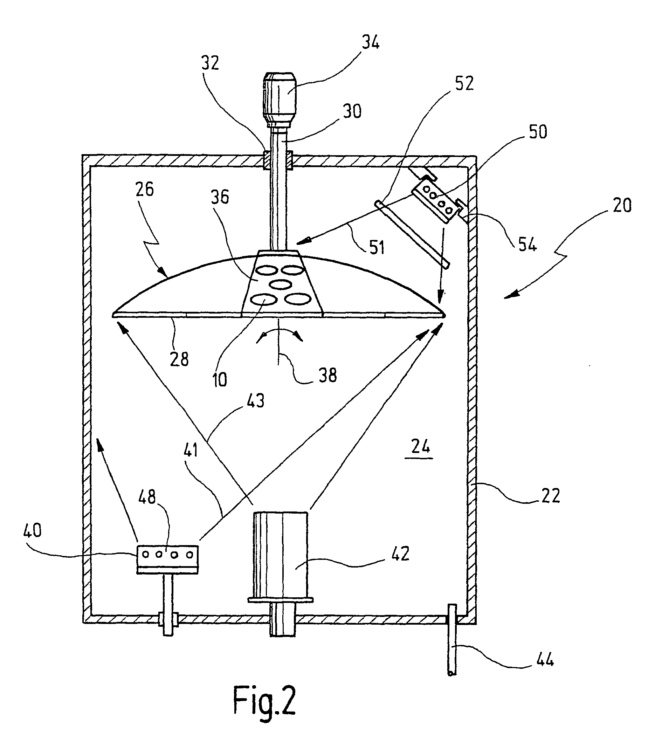

In Fig. 2 ist eine in ihrer Gesamtheit mit der Bezugsziffer 20 versehene Vakuumbeschichtungsanlage dargestellt, in der die zuvor erwähnten unterschiedlichen Schichten 12, 14 und 18 auf das Substrat 10 aufgebracht werden können.

Die Vakuumbeschichtungsanlage 20 weist ein Gehäuse 22 auf, in dessen Innerem eine Kammer 24 gebildet ist.

In der Kammer 24 ist ein Substrathalter 26 aufgenommen, der die Form einer Kalotte 28 aufweist.

Die Kalotte 28 ist am oberen Ende mit einer Achswelle 30 verbunden, die durch ein Lager 32 in der oberen Wand der Kammer 24 hindurchgeführt ist und mit einem Antrieb 34 verbunden ist.

Auf dem kalottenförmigen Substrathalter 26 sind zahlreiche Federringe vorgesehen, in denen die Substrate 10 eingeschoben werden können.

Die Größenverhältnisse sind hier nicht realistisch dargestellt, auf einem solchen Substrathalter können mehrere Dutzend Substrate aufgenommen werden.

Falls mit einer Wendetechnik gearbeitet werden soll, kann die Kalotte 28 aus einzelnen etwa trapezförmigen Paddeln 36 zusammengesetzt sein, wie das hier angedeutet ist, die über einen nicht näher gezeigten Mechanismus um deren Längsachse 38 drehbar sind.

Unterhalb der Kalotte 28 ist ein Elektronenstrahlverdampfer 40 angeordnet, in dem die Materialien, die die einzelnen Schichten bilden sollen, verdampft werden können.

Das vom Elektronenstrahlverdampfer 40 verdampfte Material wird in einem Strahl, wie er durch die Pfeile 41 angedeutet ist, in Richtung Substrathalter 26 ausgestrahlt.

Die verdampfbaren Ausgangsmaterialien, z.B. Oxide und Fluoride, können als Granulat oder als Plattenmaterial eingesetzt werden.

Das Verdampfen des Materials wird durch Anlegen eines entsprechenden Unterdrucks in der Kammer 24 (z.B. 10⁻⁶ mbar) und Heizen des Materials im Elektronenstrahlverdampfer 40 bewerkstelligt.

Genaue Bedingungen sind beispielsweise in der DE 44 30 363 A1 beschrieben, auf die hier ausdrücklich Bezug genommen wird.

Unterhalb des Substrathalters 46 ist auch eine Plasmaquelle 42 angeordnet, die einen Plasmastrom erzeugt, wie das durch die Pfeile 43 in Fig. 2 dargestellt ist.

Die Plasmaquelle 42 weist beispielsweise eine zylindrische Elektronen emittierende LaB₆-Kathode auf, die von einer zylindrischen Anode umgeben ist. Dabei wird ein Glimmentladungs-Plasma erzeugt, wobei ein Edelgas, in erster Linie Argon, über eine Leitung 44 in die Kammer 24 eingeführt wird. Eine zylindrische Magnetspule, die die Anode umrundet, bewirkt, dass die Bewegungsmöglichkeit der Elektronen, welche das Plasma erzeugen, in axialer Richtung erheblich vergrößert und in radialer Richtung erheblich verringert wird. Im Bereich der oberen Wand der Beschichtungskammer und über dem Substrathalter ist eine ringförmige - hier nicht näher dargestellte - Magnetspule angeordnet. Das Magnetfeld dieser Ringspule überlagert sich mit dem Magnetfeld der die Anode umgebenden Zylinderspule und führt zu dem Plasma, wobei vor dem kuppelförmigen Substrathalter eine kuppelförmige Plasmarandschicht erzeugt wird. Aufgrund des relativ zum Plasma negativen Potentials des Substrathalters 26 werden Ionen aus der Plasmarandschicht heraus beschleunigt und bombardieren einen wachsenden Film, der dadurch verdichtet wird. Das vom Elektronenstrahlverdampfer 40 verdampfte Material wird ebenfalls ionisiert und aktiviert.

Durch die unabhängige Ausbildung von Elektronenstrahlverdampfer 40 und Plasmaquelle 42 kann der Elektronenstrahlverdampfer 40 mit dem jeweilig geeigneten Material bestückt werden, beispielsweise auch mit dem Material zum Herstellen der abschließenden hydrophoben Schicht 18, also beispielsweise Tetramethyldisiloxan (TMDS).

Das heißt, der Elektronenstrahlverdampfer 40 arbeitet in diesem Fall als ein erster Verdampfer 48 zum Verdampfen des Materials zum Ausbilden der hydrophoben Schicht 18 auf der Seite der Substrate 10, die dem Boden der Kammer 24 zugewandt sind.

Wie aus Fig. 2 zu entnehmen ist, ist auf der gegenüberliegenden Seite der Substrate 10, also über dem Substrathalter 26, ein zweiter Verdampfer 50 angeordnet.

Der zweite Verdampfer 50 ist seitlich über dem Substrathalter 26 angeordnet und über eine Halterung 54 in der Kammer 24 gehalten.

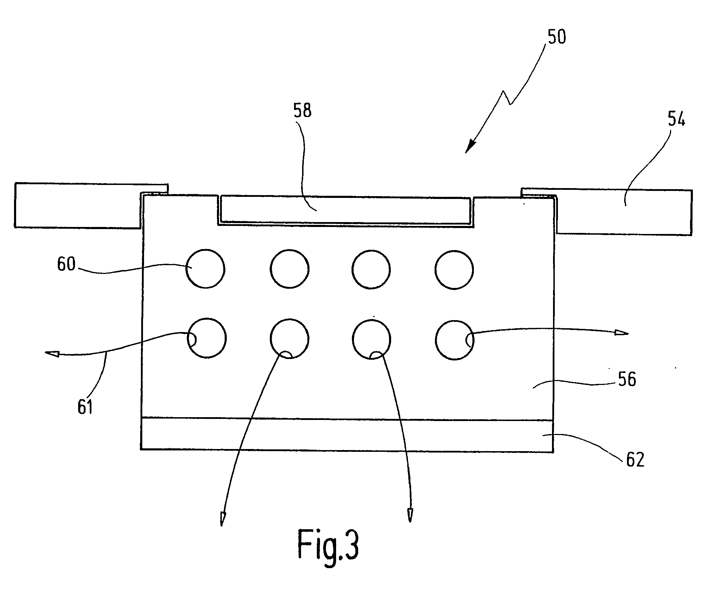

In Fig. 3 ist dieser zweite Verdampfer 50 näher dargestellt.

Der zweite Verdampfer 50 weist einen allseits geschlossenen Behälter 56 in Form eines Schiffchens auf, der einen verschiebbaren Deckel 58 aufweist.

In den Seitenwänden, insbesondere in der Seitenwand, die dem Substrathalter 26 zugewandt ist, sind zahlreiche Öffnungen 60 vorgesehen, die dazu dienen, dass das im Verdampfer 50 aufgenommene Material nach dem Verdampfen austreten kann, wie das durch die Pfeile 61 dargestellt ist.

Bodenseitig ist der Behälter 56 mit einer Heizung 62 versehen.

Zurückkehrend zu Fig. 2 ist zu entnehmen, dass zwischen dem zweiten Verdampfer 50 und der Oberseite des Substrathalters 26 noch eine Blende 52 angeordnet ist, die zur Fokussierung bzw. Ausblenden des aus dem zweiten Verdampfers 50 austretenden verdampften Materials dient, um somit eine entsprechend gewünschte Verteilung dieses Materials auf die Oberseite des Substrathalters 26 zu bewerkstelligen.

Der Substrathalter 26, der sich um die Achswelle 30 dreht, wird entsprechend nach und nach unter der Blende 52 hindurchgeführt.

Im zuvor beschriebenen Ausführungsbeispiel ist der untere erste Verdampfer 48 ein Teil des Elektronenstrahlverdampfers 40, der herangezogen wird, um alle aufzuschichtenden Materialien zu verdampfen.

Im weiteren hier nicht dargestellten Ausführungsbeispielen ist vorgesehen, dass zwei zweite Verdampfer 50 spiegelbildlich angeordnet sind, also einer über dem Subhalter 26 und einer unter dem Substrathalter 26.

Dann arbeiten diese beiden Verdampfer völlig unabhängig von dem Elektronenstrahlverdampfer, der dann lediglich dazu herangezogen wird, die unter der hydrophoben Schicht liegenden Schichten aufzubauen.

Dies zeigt die Flexilibität bzw. auch die Möglichkeit, schon bestehende Anlagen lediglich mit einem zweiten Verdampfer 50 nachzurüsten.

## Patentansprüche

1. Vorrichtung zum beidseitigen Beschichten von Substraten (10) in einer Vakuumbeschichtungsanlage (20), mit einem Substrathalter (26), mit einem Elektronenstrahlverdampfer (40), der auf einer Seite des Substrathalters (26) angeordnet ist, über den unterschiedliche Schichten (12, 14) nach und nach beidseitig auf die Substrate (10) aufbringbar sind, und mit einem auf der einen Seite des Substrathalters (26) angeordneten ersten Verdampfer (48) zum Verdampfen eines eine hydrophobe Schicht (18) bildenden Stoffes, sowie mit einem auf der der einen Seite gegenüberliegenden anderen Seite angeordneten zweiten Verdampfer (50) zum Verdampfen eines eine hydrophobe Schicht (18) bildenden Stoffes.

2. Vorrichtung nach Anspruch 1, **dadurch gekennzeichnet, dass** der zweite Verdampfer (50) einen Behälter (56) aufweist, der mehrere Austrittsöffnungen (60) aufweist.

3. Vorrichtung nach Anspruch 1 oder 2, **dadurch gekennzeichnet, dass** der Behälter (56) in einer Halterung (54) lösbar aufgenommen ist.

4. Vorrichtung nach einem der Ansprüche 1 bis 3, **dadurch gekennzeichnet, dass** zwischen dem zweiten Verdampfer (50) und dem Substrathalter (26) eine Blende (52) angeordnet ist.

5. Vorrichtung nach einem der Ansprüche 1 bis 4, **dadurch gekennzeichnet, dass** erster und zweiter Verdampfer als einzelne Gerätschaften ausgebildet sind.

6. Vorrichtung nach einem der Ansprüche 1 bis 5, **dadurch gekennzeichnet, dass** erster und zweiter Verdampfer gleich ausgebildet sind.

7. Vorrichtung nach einem der Ansprüche 1 bis 4, **dadurch gekennzeichnet, dass** der erste Verdampfer (48) Bauteil eines Elektronenstrahlverdampfers (40) ist.

8. Vorrichtung nach einem der Ansprüche 1 bis 7, **dadurch gekennzeichnet, dass** der erste Verdampfer (48) unterhalb des Substrathalters (26) und das der zweite Verdampfer (50) oberhalb des Substrathalters (26) angeordnet ist.

9. Vorrichtung nach einem der Ansprüche 1 bis 8, **dadurch gekennzeichnet, dass** der Substrathalter (26) kalottenförmig ausgebildet ist.

10. Verfahren zum beidseitigen Beschichten von Substraten (10) in einer Vakuumbeschichtungsanlage (20), bei dem auf von einem Substrathalter (26) gehaltenen Substraten (10) mittels eines Elektronenstrahlverdampfers (40) nach und nach unterschiedliche Schichten (12, 14) beidseitig auf die Substrate (10) aufgebracht werden, und bei dem anschließend eine Seite der Substrate (10) mittels eines auf dieser Seite angeordneten ersten Verdampfers (48) mit einer hydrophoben Schicht (18) beschichtet werden, und eine andere gegenüberliegende Seite mit einem auf dieser anderen Seite angeordneten zweiten Verdampfer (48) mit einer hydrophoben Schicht (48) beschichtet werden.

11. Verfahren nach Anspruch 10, **dadurch gekennzeichnet, dass** die vom Elektronenstrahlverdampfer (40) nach und nach aufgebrachten Schichten (12, 14) mit hoher Maßgenauigkeit aufgebracht werden.

12. Verfahren nach Anspruch 10 oder 11, **dadurch gekennzeichnet, dass** vom Elektronenstrahlverdampfer (40) eine abriebfeste Schicht (12) und eine reflexreduzierende Schicht (14) aufgebracht werden.

## Claims

1. Device for coating both sides of substrates (10) in a vacuum coating system (20), with a substrate holder (26), with an electron beam evaporator (40), arranged on one side of the substrate holder (26), via which electron beam evaporator (40) different layers (12, 14) can be deposited one by one onto both sides of the substrates (10), and with a first evaporator (48) for evaporating a compound forming a hydrophobic layer (18), which first evaporator (48) is arranged on one side of the substrate holder (26) and with a second evaporator (50) for evaporating a compound forming a hydrophobic layer (18) which second evaporator (50) is arranged on a side opposite to the one side.

2. Device of claim 1, **characterized in that** the second evaporator (50) has a container (56) which has a number of outlet openings (60).

3. Device of claims 1 or 2, **characterized in that** the container (56) is releasably accommodated in a mounting (54).

4. Device of anyone of claims 1 through 3, **characterized in that** a shutter (52) is arranged between the second evaporator (50) and the substrate holder.

5. Device of anyone of claims 1 through 4, **characterized in that** the first and the second evaporators are formed as individual pieces of equipment.

6. Device of anyone of claims 1 through 5, **characterized in that** the first and the second evaporators are designed identically.

7. Device of anyone of claims 1 through 4, **characterized in that** the first evaporator (48) is a component of the electron beam evaporator (40).

8. Device of anyone of claims 1 through 7, **characterized in that** the first evaporator (48) is arranged under the substrate holder (26) and **in that** the second evaporator (50) is arranged above the substrate holder (26).

9. Device of anyone of claims 1 through 8, **characterized in that** the substrate holder (26) has the form of a spherical cup.

10. Method for coating both sides of substrates (10) in a vacuum coating system (20) wherein onto substrates (10) held by a substrate holder (26) different layers (12, 14) are deposited one by one on both sides of the substrates (10) via an electron beam evaporator (40), and wherein subsequently one side of the substrates (10) is coated with a hydrophobic layer (18) via a first evaporator (48) arranged on that one side, and wherein the other, opposite side is layered with a hydrophobic layer (18) with a second evaporator (50) arranged on a side opposite to the one side.

11. Method of claim 10, **characterized in that** the layers (12, 14) deposited by the electron beam evaporator (40) one by one are deposited with a high dimensional stability.

12. Method of claims 10 or 11, **characterized in that** an abrasion-resistant layer (12) and a reflection-reducing layer (14) is deposited via the electron beam evaporator (40).

## Revendications

1. Dispositif de revêtement bilatéral de substrats (10) dans une installation de revêtement sous vide (20), avec un porte-substrats (26), avec un évaporateur à faisceau électronique (40) qui est disposé d'un côté du porte-substrats (26), par l'intermédiaire duquel différentes couches (12, 14) peuvent être appliquées progressivement des deux côtés sur les substrats (10), et avec un premier évaporateur (48) disposé d'un côté du porte-substrats (26) pour vaporiser une substance formant une couche hydrophobe (18) ainsi qu'avec un deuxième évaporateur (50) disposé de l'autre côté, opposé audit un côté, pour vaporiser une substance formant une couche hydrophobe (18).

2. Dispositif selon la revendication 1, **caractérisé en ce que** le deuxième évaporateur (50) présente un réservoir (56) qui présente plusieurs ouvertures de sortie (60).

3. Dispositif selon la revendication 1 ou 2, **caractérisé en ce que** le réservoir (56) est logé de manière détachable dans un support (54).

4. Dispositif selon l'une des revendications 1 à 3, **caractérisé en ce qu'**un diaphragme (52) est disposé entre le deuxième évaporateur (50) et le porte-substrats (26).

5. Dispositif selon l'une des revendications 1 à 4, **caractérisé en ce que** le premier et le deuxième évaporateurs sont réalisés sous la forme d'appareils individuels.

6. Dispositif selon l'une des revendications 1 à 5, **caractérisé en ce que** le premier et le deuxième évaporateurs sont réalisés sous une forme identique.

7. Dispositif selon l'une des revendications 1 à 4, **caractérisé en ce que** le premier évaporateur (48) est un composant d'un évaporateur à faisceau électronique (40).

8. Dispositif selon l'une des revendications 1 à 7, **caractérisé en ce que** le premier évaporateur (48) est disposé au-dessous du porte-substrats (26) et que le deuxième évaporateur (50) est disposé au-dessus du porte-substrats (26).

9. Dispositif selon l'une des revendications 1 à 7, **caractérisé en ce que** le porte-substrats (26) est réalisé en forme de calotte.

10. Procédé de revêtement bilatéral de substrats (10) dans une installation de revêtement sous vide (20), dans lequel différentes couches (12, 14) sont appliquées progressivement au moyen d'un évaporateur à faisceau électronique (40) des deux côtés de substrats (10) tenus sur un porte-substrats (26), et dans lequel ensuite un côté des substrats (10) est revêtu d'une couche hydrophobe (18) au moyen d'un premier évaporateur (48) disposé de ce côté, et un autre côté opposé est revêtu d'une couche hydrophobe (48) avec un deuxième évaporateur (48) disposé de cet autre côté.

11. Procédé selon la revendication 10, **caractérisé en ce que** les couches (12, 14) appliquées progressivement par l'évaporateur à faisceau électronique (40) sont appliquées avec une précision dimensionnelle élevée.

12. Procédé selon la revendication 10 ou 11, **caractérisé en ce qu'**une couche résistante à l'abrasion (12) et une couche antireflet (14) sont appliquées par l'évaporateur à faisceau électronique (40).
